(19) Europäisches Patentamt
European Patent Office
Office européen des brevets

(11) **EP 2 157 699 A1**

(12) **DEMANDE DE BREVET EUROPEEN**

(43) Date de publication:
**24.02.2010 Bulletin 2010/08**

(51) Int Cl.:
**H03M 1/20** *(2006.01)* **H03M 1/18** *(2006.01)*
**H03M 1/16** *(2006.01)* **H03M 1/44** *(2006.01)*
**H03M 1/46** *(2006.01)* **H03M 1/56** *(2006.01)*

(21) Numéro de dépôt: **09166339.3**

(22) Date de dépôt: **24.07.2009**

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **18.08.2008 FR 0855608**

(71) Demandeur: **STMicroelectronics SA**
**92120 Montrouge (FR)**

(72) Inventeurs:
• **Simony, Laurent**
**38100, GRENOBLE (FR)**
• **Vogt, Lionel**
**38400, SAINT MARTIN D'HERES (FR)**

(74) Mandataire: **de Beaumont, Michel**
**Cabinet Beaumont**
**1, rue Champollion**
**38000 Grenoble (FR)**

(54) **Convertisseur analogique-numérique**

(57) L'invention concerne un procédé de conversion analogique-numérique sur n bits d'un signal analogique (Vin), comportant les étapes de : comparer l'amplitude du signal analogique par rapport à un seuil représentant l'amplitude (Vref) du signal analogique à pleine échelle divisée par $2^k$, où k est un entier inférieur à n ; effectuer une conversion analogique-numérique du signal analogique sur n-k bits pour obtenir les n-k bits de poids fort d'un mot binaire sur n bits si le résultat de l'étape de comparaison indique que l'amplitude du signal d'entrée est supérieure au seuil, et les n-k bits de poids faible de ce mot binaire sinon. L'invention concerne également un convertisseur analogique-numérique et son application aux capteurs d'images.

Fig 3

EP 2 157 699 A1

**Description**

Domaine de l'invention

La présente invention concerne de façon générale la conversion de signaux analogiques en signaux numériques et, plus particulièrement, une telle conversion appliquée à des signaux issus de capteurs d'image.

Exposé de l'art antérieur

Les convertisseurs analogiques-numériques sont utilisés dans les capteurs d'images pour convertir un signal analogique représentatif de l'éclairement capté par une photodiode en un signal numérique pour mémorisation et traitement dans des circuits numériques. La précision de l'information stockée sous forme numérique dépend non seulement de la précision des circuits analogiques mais également du nombre de bits sur lequel ce signal analogique est converti. Toutefois, plus le nombre de bits du convertisseur est élevé, plus celui-ci prend de la place et/ou plus le temps de conversion est important.

Deux types de bruits sont susceptibles d'influencer le rapport signal/bruit du convertisseur. A petit signal, un bruit dit de lecture, lié à la chaîne d'acquisition et indépendant du niveau du signal, prédomine. Le niveau de ce bruit conditionne l'équivalent analogique du bit de poids faible. A ce bruit s'ajoute un bruit lié au signal. Ce bruit, dit bruit photonique, est proportionnel à la racine carrée du nombre d'électrons reçus par le capteur.

Dans un capteur d'image, un convertisseur est généralement affecté à chaque colonne de pixels du capteur et les conversions sont effectuées simultanément pour les pixels d'une même ligne. Par conséquent, lorsqu'on accroît le nombre de bits de conversion, l'augmentation en taille qui en résulte est à multiplier par le nombre de colonnes et l'accroissement en temps de traitement est à multiplier par le nombre de lignes.

Côté signal analogique, une fois le bruit de lecture inférieur au bruit photonique, le rapport signal sur bruit est égal à $N/\sqrt{N}$, où N représente le nombre d'électrons reçus par le capteur.

On a déjà proposé de tenir compte du bruit photonique dans un capteur d'images en faisant varier la pente de la rampe d'un convertisseur à rampe. Cela revient à se contenter, pour les signaux forts, d'une résolution plus grossière qu'à petit signal. En fait, la pente de la rampe augmente avec le temps sur une période de mesure. Une telle solution est décrite dans l'article "A Low-Power Column-Parallel 12-bit ADC for CMOS Imagers" de M.F. Snoeij et al. (Delft University of Technology) publié en juin 2005.

Pour un encombrement donné, une solution à rampe variable n'accroît pas le nombre de bits fournis par le convertisseur, mais permet de gagner du temps en diminuant le nombre de niveaux de quantification. De plus, le temps de réponse des comparateurs du convertisseur dépend de la pente de la rampe. La rampe variable est donc susceptible d'engendrer une erreur de quantification.

Il serait souhaitable de pouvoir augmenter la résolution d'un convertisseur analogique-numérique sans pour autant accroître sa complexité ou son temps de traitement.

A titre d'exemple, on cherche de plus en plus à passer de 10 à 12 bits pour les signaux numériques fournis par des capteurs d'images.

Résumé de l'invention

La présente invention vise à pallier tout ou partie des inconvénients des convertisseurs analogiques-numériques connus, pour des applications où le bruit dépend de l'amplitude du signal.

Un objet vise plus particulièrement à augmenter le nombre de bits d'un convertisseur analogique-numérique sans trop augmenter ni la complexité, ni le temps de traitement.

Un autre objet vise une solution particulièrement adaptée aux capteurs d'images.

Pour atteindre tout ou partie de ces objets ainsi que d'autres, il est prévu un procédé de conversion analogique-numérique sur n bits d'un signal analogique, comportant les étapes de :

comparer l'amplitude du signal analogique par rapport à un seuil représentant l'amplitude du signal analogique à pleine échelle divisée par $2^k$, où k est un entier inférieur à n ;
effectuer une conversion analogique-numérique du signal analogique sur n-k bits pour obtenir les n-k bits de poids fort d'un mot binaire sur n bits si le résultat de l'étape de comparaison indique que l'amplitude du signal d'entrée est supérieure au seuil, et les n-k bits de poids faible de ce mot binaire sinon.

Selon un mode de réalisation, la conversion analogique-numérique sur n-k bits prend pour valeur de pleine échelle, une valeur égale à $Vref/2^{(k*(1-R))}$, le quantum de la conversion sur n-k bits valant alors $Vref/2^{(n-k*R)}$, où R représente une variable binaire prenant la valeur 0 si l'amplitude du signal analogique est inférieure ou égale au seuil et la valeur 1 sinon ; et le mot binaire sur n bits est formé en multipliant le résultat de ladite conversion sur n-k bits par $2^{(k*R)}$.

Selon un mode de réalisation, si l'amplitude du signal d'entrée est supérieure au seuil, les k bits de poids faible du mot sur n bits sont obtenus de façon aléatoire.

Il est également prévu un convertisseur analogique-numérique sur n bits d'un signal analogique, comportant :

un élément de comparaison de l'amplitude du signal analogique par rapport à un seuil représentant l'amplitude du signal analogique à pleine échelle divisée par $2^k$, où k est un entier inférieur à n ; et

un élément de conversion analogique-numérique du signal analogique sur n-k bits pour obtenir les n-k bits de poids fort d'un mot binaire sur n bits si le résultat de l'étape de comparaison indique que l'amplitude du signal d'entrée est supérieure au seuil, et les n-k bits de poids faible de ce mot binaire sur n bits sinon.

Selon un mode de réalisation du convertisseur, celui-ci comporte en outre :

un élément de mémorisation d'une information binaire R fournie par l'élément de comparaison et valant 1 si l'amplitude du signal analogique est supérieure au seuil ; et
au moins un premier élément numérique apte à former un mot binaire sur n bits en multipliant la valeur obtenue en sortie de l'élément de conversion sur n-k bits par $2^{k*R}$, la pleine échelle de l'élément de conversion analogique-numérique sur n-k bits étant ajustée à la valeur $Vref/2^{(k*R)}$.

Selon un mode de réalisation du convertisseur, celui-ci comporte en outre un second élément numérique apte à additionner, dans le cas où l'information binaire R vaut 1, un nombre aléatoire au mot binaire sur n bits fourni par le premier élément numérique, la sortie du deuxième élément numérique constituant la sortie du convertisseur.

Selon un mode de réalisation du convertisseur, l'élément de conversion est un convertisseur à rampe utilisant deux rampes distinctes dont le rapport des pentes vaut $2^k$, le convertisseur comportant en outre un élément de connexion dudit élément de comparaison à l'une des deux rampes en fonction de la valeur de l'information binaire R.

Selon un mode de réalisation du convertisseur, l'élément de conversion est à approximations successives, lesdits éléments de comparaison et de conversion étant constitués d'un même comparateur, et le convertisseur comportant en outre un élément de sélection de la valeur de pleine échelle en fonction de la valeur de l'information binaire R.

Selon un mode de réalisation du convertisseur, l'élément de conversion est de type pipeline, le convertisseur comportant en outre, en amont de l'élément de conversion, un étage dont le gain est sélectionné en fonction de la valeur de l'information binaire R.

Il est également prévu un capteur d'images comportant :

un réseau de pixels comportant chacun au moins un élément de stockage d'une information de luminance ;
au moins un convertisseur analogique-numérique ; et

au moins un élément de mémorisation.

Il est également prévu un système électronique comportant :

au moins un circuit apte à fournir un signal analogique à convertir en signal numérique ;
au moins un convertisseur analogique-numérique ; et
au moins un circuit apte à exploiter le signal numérique.

Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :

la figure 1 est une vue schématique d'un capteur d'image du type auquel s'applique à titre d'exemple la présente invention ;
la figure 2 représente une caractéristique de tension analogique de sortie en fonction de l'intensité d'éclairement dans un pixel d'un capteur d'images, ainsi que le niveau de bruit (photonique et de lecture) et le rapport signal/bruit ;
la figure 3 illustre un mode de mise en oeuvre d'un convertisseur analogique-numérique ;
la figure 4 illustre la caractéristique de tension analogique fournie par un pixel d'un capteur d'image par rapport à l'intensité d'éclairement illustrant l'application de l'invention ;
la figure 5 représente sous forme de blocs, un mode de réalisation d'architecture de convertisseur analogique-numérique ;
les figures 6A à 6F illustrent le fonctionnement de l'architecture de la figure 5 ;
la figure 7 est un schéma bloc d'un mode de réalisation d'un convertisseur analogique-numérique à approximations successives ;
la figure 8 est un schéma-bloc plus détaillé d'un exemple de réalisation d'un convertisseur à approximations successives tel que celui de la figure 7 ;
la figure 9 représente un mode de réalisation d'un convertisseur analogique-numérique de type pipeline.

De mêmes éléments ont été désignés par de mêmes références aux différentes figures.

Description détaillée

Par souci de clarté, seules les étapes et éléments utiles à la compréhension de l'invention ont été représentés et seront décrits. En particulier, les mécanismes d'acquisition des signaux analogiques, notamment dans un capteur d'image, n'ont pas été détaillés, l'invention étant compatible avec toute acquisition usuelle. De plus, l'utilisation faite des signaux numériques fournis par le convertisseur n'a pas non plus été détaillée, l'invention étant là encore compatible avec toute utilisation usuelle.

La présente invention sera décrite plus particulièrement en relation avec un exemple d'application aux capteurs d'images. Elle s'applique toutefois plus généralement à toute conversion analogique-numérique dans laquelle des problèmes analogues sont susceptibles de se poser et notamment dans laquelle le niveau de bruit varie avec l'amplitude du signal utile. Par exemple, l'invention s'applique également à des systèmes de conversion de puissance, à des systèmes de contrôle de la puissance émise dans une chaîne de transmission radio ou dans un contrôle de gain, où une information d'enveloppe est extraite du signal avec une partie utile variant dans une très grande plage et où une perturbation varie avec l'amplitude à mesurer.

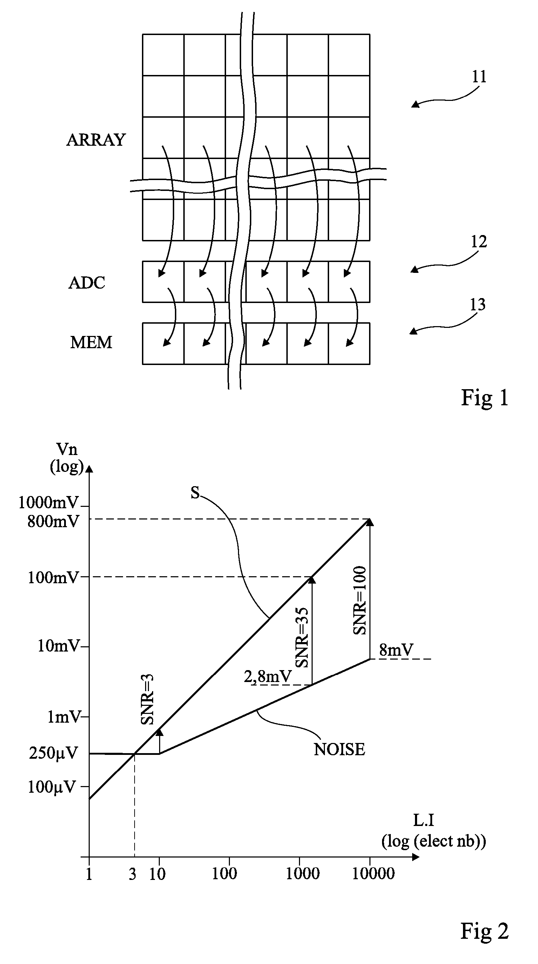

La figure 1 est une vue schématique sous forme de blocs d'un capteur d'image du type auquel s'applique à titre d'exemple la présente invention.

Un tel capteur comporte un réseau 11 (ARRAY) de pixels comprenant chacun au moins un élément de stockage d'une information de luminance captée par une photodiode (non représentée). Le réseau matriciel est exploité dans une direction (par exemple en colonne), c'est-à-dire que l'information de luminance stockée dans le pixel ou dans un élément de mémorisation intermédiaire est fournie, pour toutes les colonnes d'une même ligne 12, à une ligne de convertisseurs analogique-numérique (ADC) dont les résultats respectifs sont stockés dans des éléments de mémorisation 13 (MEM) pour exploitation ultérieure.

La figure 2 représente l'évolution de la tension Vin d'un pixel en fonction de l'intensité lumineuse LI captée par la photodiode ainsi que le niveau de bruit (photonique et de lecture) et le rapport signal/bruit. La représentation de la figure 2 est en échelle logarithmique, l'intensité lumineuse étant exprimée en nombre d'électrons.

Dans un capteur d'images, le niveau du signal S en fonction de l'intensité lumineuse suit une allure approximativement linéaire et de pente constante en échelle logarithmique. Par ailleurs, plus le nombre d'électrons collectés par un pixel augmente, plus le bruit photonique (shot noise) augmente. Dès que le bruit de lecture est dépassé, le bruit NOISE représente le bruit photonique qui est proportionnel à $\sqrt{N}$, où N représente le nombre d'électrons collectés par la photodiode du pixel. Le contributeur prépondérant du bruit NOISE est le bruit photonique. Il en découle que le rapport signal sur bruit SNR évolue également en $\sqrt{N}$. Comme l'illustre la figure 2, le bruit de lecture domine pour les petits signaux (faible éclairement du capteur). Afin d'être en mesure d'exploiter correctement les résultats, la résolution du convertisseur analogique-numérique doit être choisie en fonction de ce bruit de lecture. En pratique, on choisit une résolution qui correspond approximativement au bruit de lecture pour les petits signaux.

Toutefois, pour un signal élevé, le niveau de bruit devient tel que plusieurs des bits fournis par le convertisseur ne sont plus significatifs.

L'article "A Low-Power Column-Parallel 12-bit ADC for CMOS Imagers" mentionné précédemment exploite le phénomène de bruit photonique pour proposer un convertisseur analogique-numérique à rampe variable au cours du temps. Ce document prévoit, dans une architecture de convertisseur simple rampe, une rampe dont le pas augmente avec la valeur de tension de la rampe en rapport avec le bruit attendu sur le signal correspondant. Cela permet de réduire le temps de conversion par rapport à un convertisseur simple rampe.

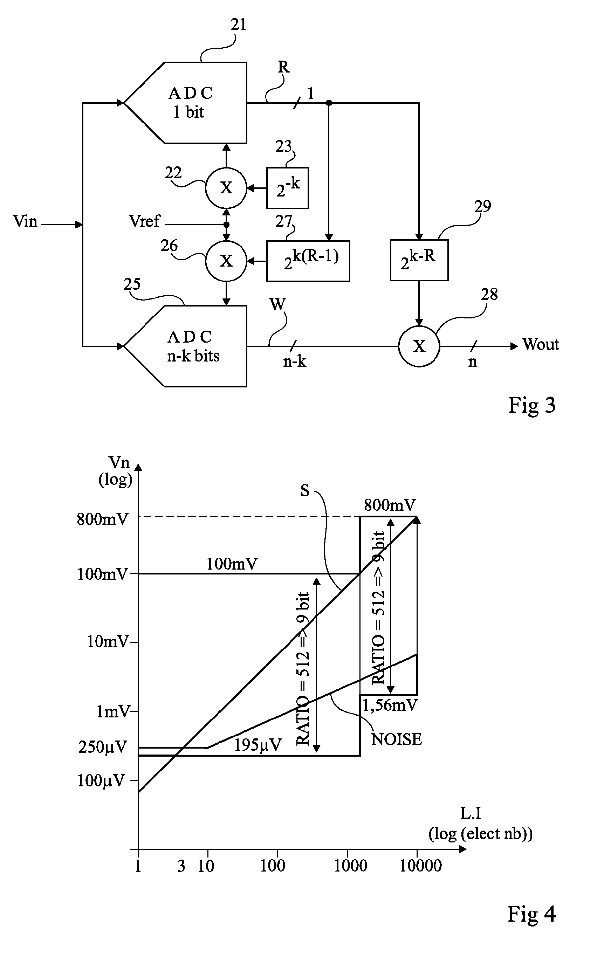

La figure 3 est un schéma blocs fonctionnel d'un mode de réalisation d'un convertisseur analogique-numérique d'un signal analogique Vin (provenant par exemple d'un pixel d'un capteur d'images) en un mot numérique Wout sur n bits.

La figure 4 est un graphe illustrant le fonctionnement du convertisseur de la figure 3. Le graphe de la figure 4 est à rapprocher de celui de la figure 2.

La conversion opérée commence par déterminer une plage d'amplitudes dans laquelle se situe le signal Vin à numériser. Cette détermination est illustrée en figure 3 par un convertisseur 21 (ADC 1 bit) sur un seul bit de la tension Vin par rapport à un niveau de tension Vref*$2^{-k}$ (multiplieur 22 et bloc 23 fournissant une valeur $2^{-k}$). Cela revient à comparer l'amplitude du signal Vin à un seuil Vref/$2^{-k}$. Le convertisseur 21 fournit un bit R indicateur de la plage du signal d'entrée. Le nombre n-k (n et k étant des nombres entiers) représente le nombre de bits sur lequel est convertie la plage utile du signal. Dans l'exemple de la figure 4, on suppose un nombre n-k de 9 bits pour obtenir un convertisseur sur n=12 bits.

Une fois la plage déterminée, le bit R est utilisé pour déterminer la tension de référence Vref*$2^{k(R-1)}$ d'un deuxième convertisseur 25 (ADC n-k bits) du signal d'entrée Vin (multiplieur 26 et bloc 27 calculant la valeur k(R-1)). Le convertisseur 25 fournit un mot W sur n-k bits qui représente la conversion de la partie utile du signal. Enfin, le mot W est multiplié par $2^{k*R}$ (multiplieur 28 et bloc 29) ou soumis à toute opération équivalente pour fournir un mot Wout sur n bits. La multiplication 28 revient à sélectionner si les n-k bits du mot W sont côté bits de poids faible (LSB) ou côté bits de poids fort (MSB) du résultat Wout sur n bits. Ainsi, en variante, d'autres traitements qu'une multiplication pourront être prévus pour obtenir les n-k bits de poids fort d'un mot binaire sur n bits si le résultat de l'étape de comparaison indique que l'amplitude du signal d'entrée est supérieure au seuil, et les n-k bits de poids faible de ce mot binaire sinon. Le niveau de référence minimal Vref/$2^n$ est choisi pour correspondre approximativement au niveau de bruit à petit signal du signal Vin à numériser, le niveau Vref correspondant à la pleine échelle du signal. On peut considérer que l'on utilise un convertisseur de faible résolution (sur un bit dans cet exemple) pour déterminer la plage d'amplitudes dans laquelle se situe le signal utile, et un convertisseur de résolution élevée pour convertir ce signal utile. Le quantum du convertisseur global sur n bits (plus petit niveau de tension analogique détectable - valeur analogique de l'incrément d'un bit) reste égal, quelle que soit la plage, à $Vref/2^n$. Le quantum de la conversion du signal utile sur n-k bits dépend de la plage dans laquelle il se situe.

La résolution du convertisseur ne varie pas (n bits pour le convertisseur global - n-k bits pour le convertisseur "effectif"). La pleine échelle de la conversion dépend de la comparaison préalable et vaut $Vref/2^{(k*R)}$.

Par rapport à un convertisseur à rampe variable, une différence est que l'on n'effectue pas de conversion avec le convertisseur sur la plage entière (n bits). Ainsi, non seulement on gagne du temps mais on simplifie l'architecture du convertisseur, donc la surface qu'il occupe.

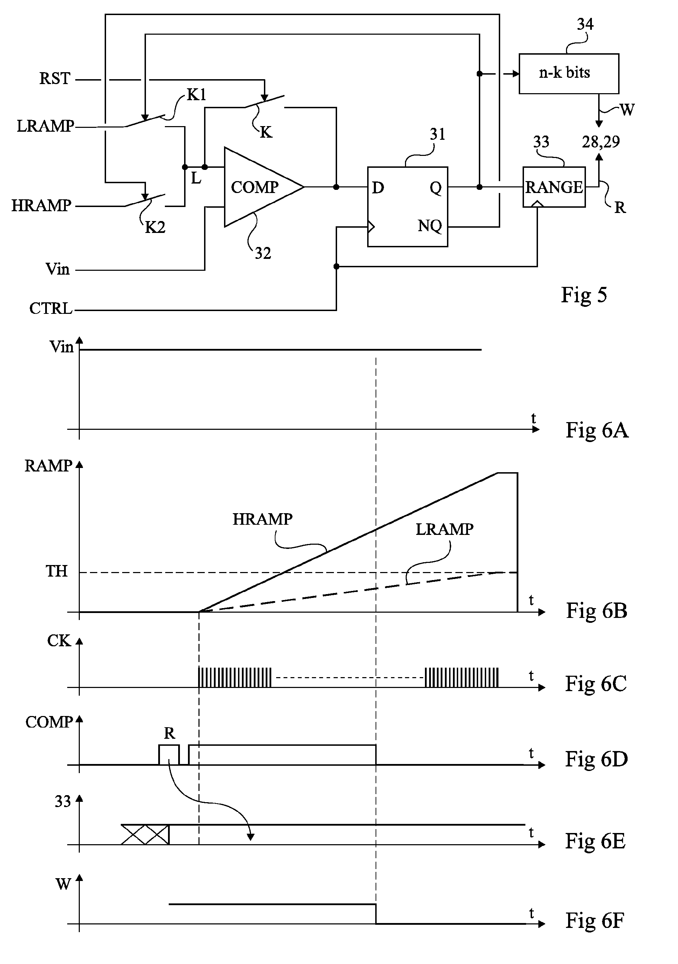

La figure 5 est une représentation schématique d'un mode de réalisation d'un convertisseur analogique-numérique dit à rampe. Cet exemple est basé sur l'utilisation d'un point mémoire (par exemple, une bascule 31 de type D) dont l'entrée de données reçoit le résultat fourni par un comparateur 32 (COMP) de la tension d'entrée Vin par rapport à un niveau L. Ce niveau L est, pour la numérisation sur n-k bits, fourni par un générateur de rampe linéaire (non représenté) fournissant une rampe de pente relativement forte HRAMP ou de pente relativement faible LRAMP selon la plage (bloc 33, RANGE) dans laquelle se situe le signal Vin. Dans le mode de réalisation représenté, le comparateur 32 sert à la fois à la conversion du signal sur les n-k bits et à la sélection de la plage d'amplitude du signal utile. Le comparateur 32 est susceptible d'être réinitialisé par un interrupteur K, commandé par un signal RST et qui relie son entrée recevant le niveau de comparaison L à sa sortie directe Q. La sortie directe Q de la bascule 31 commande un premier interrupteur K1 de sélection de la rampe LRAMP tandis que la sortie inverse NQ commande un interrupteur K2 de sélection de la rampe HRAMP. L'entrée d'horloge de la bascule 31 reçoit un signal de commande CTRL comportant une impulsion pour chaque conversion. Cette impulsion est fournie après que le comparateur 32 a effectué la comparaison.

La génération des rampes LRAMP et HRAMP peut faire appel à n'importe quel système de génération usuel. Par exemple, un générateur fournissant deux rampes, basé sur un compteur associé à un convertisseur numérique-analogique dont la tension de référence, choisie parmi deux valeurs selon la plage, fixe la pente de la rampe.

En pratique, pour effectuer la conversion sur n-k bits, le convertisseur à rampes fournit n-k+1 bits (pour tenir compte d'éventuels décalages de niveau). Le traitement de ces n-k+1 bits pour obtenir les n-k bits est usuel.

Bien entendu, l'architecture de la figure 5 est complétée par des éléments de synchronisation des périodes de fourniture du signal Vin pour conversion par rapport aux périodes de fourniture des rampes.

Les figures 6A, 6B, 6C, 6D, 6E et 6F sont des chronogrammes illustrant le fonctionnement du convertisseur de la figure 5. La figure 6A illustre un exemple de niveau du signal analogique Vin à numériser. La figure 6B illustre les deux rampes HRAMP et LRAMP en fonction du seuil TH entre les deux plages du convertisseur. Pour simplifier, ces rampes ont été représentées linéaires mais elles sont le plus souvent en escalier avec un pas temporel dépendant de la fréquence de comptage associé au convertisseur numérique-analogique de génération de la rampe. La figure 6C illustre le signal Ck d'horloge ou de comptage d'un convertisseur numérique-analogique de génération de la rampe. La figure 6D illustre le signal de sortie fourni par le comparateur 32. La figure 6E représente l'état contenu dans l'élément de mémorisation 33. La figure 6F illustre le mot W issu de la conversion, fourni par la bascule 31 et stocké dans un élément de mémorisation 34 (n-k bits). Le résultat final est obtenu comme indiqué en figure 3 en multipliant le mot W par $2^{k*R}$, où R représente l'état du registre 33. Une première comparaison est effectuée par rapport au seuil TH pour déterminer la plage dans laquelle se situe le signal d'entrée Vin. Le seuil TH correspond à l'amplitude de la rampe LRAMP, choisie pour correspondre à $Vref/2^k$.

Une fois le résultat R connu en sortie du comparateur 32, la sélection de la rampe s'effectue grâce à l'interrupteur K1 ou K2 et le signal d'entrée Vin peut être numérisé dans la plage correspondante.

Un avantage de la réalisation de la figure 5 est qu'elle permet d'utiliser un même comparateur pour à la fois détecter la plage du signal et effectuer la conversion proprement dite.

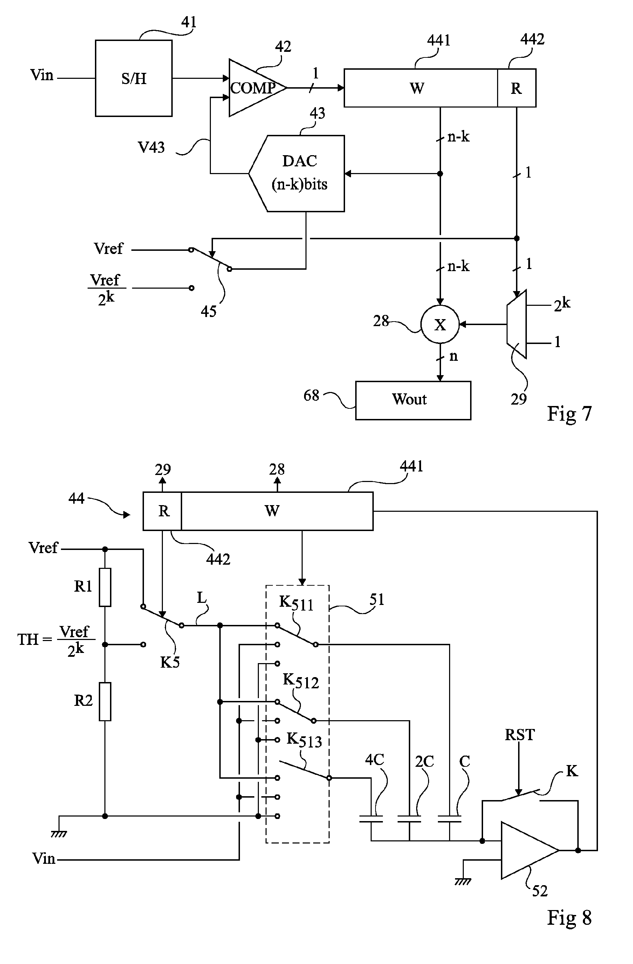

La figure 7 est un schéma bloc d'un mode de réalisation d'un convertisseur analogique-numérique dit à approximations successives. Le signal Vin est d'abord échantillonné (bloc 41, S/H). Puis, il est comparé (comparateur 42) par rapport à un signal V43 fourni par un convertisseur numérique-analogique sur n-k bits qui reçoit, en entrée, l'état stocké dans un élément de mémorisation 44 issu de la comparaison de l'approximation précédente. Jusque là, il s'agit d'un convertisseur par approximations successives usuel.

Selon le mode de réalisation représenté, l'élément de mémorisation 441 est sur n-k bits et est associé à un élément 442 de stockage d'un bit additionnel R indicateur de la plage dans laquelle se situe le signal d'entrée. Ce bit drapeau R est utilisé pour conditionner la référence du convertisseur 43 entre un niveau de référence Vref correspondant au signal maximal à convertir (pleine échelle) et un niveau $Vref/2^k$ correspondant au seuil TH entre les deux plages. Cela permet au convertisseur 43 de générer un signal V43 en fonction de la plage du signal détectée sur n-k bits (plage de résolution souhaitée). Un interrupteur 45 commandé par l'état du bit R sélectionne le signal de référence (valeur de pleine échelle) du convertisseur 43.

Une fois la plage obtenue en comparant le signal Vin au seuil TH (Vref/$2^k$), le signal Vin est numérisé dans sa plage correspondante. Puis, le mot W contenu dans le registre 44 est multiplié (multiplieur 28), soit par $2^k$, soit par 1 (multiplexeur 29) en fonction de l'état du bit R, pour fournir, par exemple à un registre 68, le résultat Wout sur n bits.

On obtient un convertisseur analogique-numérique de résolution apparente n bits à partir d'un convertisseur n-k bits. Pour cela :

le signal Vin à traiter est comparé par rapport à un niveau Vref/$2^k$ pour déterminer l'état 0 (si l'amplitude du signal Vin est inférieure ou égale au niveau Vref/$2^k$) ou 1 (si l'amplitude du signal Vin est supérieure au niveau Vref/$2^k$) d'une variable R ;

le signal Vin à traiter est converti par approximations successives sur n-k bits en prenant pour valeur de pleine échelle la valeur Vref/$2^{k*(1-R)}$ (quantum de conversion de Vref/$2^{k(n-k*R)}$) ; et

le mot de n bits est formé par traitement numérique.

La figure 8 représente un exemple plus détaillé de réalisation d'un convertisseur analogique-numérique à approximations successives du type de celui de la figure 7. L'exemple de la figure 8 correspond à un convertisseur 6 bits utilisant une architecture à capacités commutées.

Un tel convertisseur est basé sur l'utilisation de trois éléments capacitifs de capacités respectives C, 2C et 4C, et d'un réseau 51 de commutateurs K511, K512 et K513 de sélection des capacités utilisées pour chaque approximation en fonction des approximations précédentes. Les capacités commutées servent à mettre en oeuvre la fonction d'échantillonnage (41, figure 7) et une partie du convertisseur analogique-numérique (43, figure 7).

Une première électrode commune des capacités est connectée en première entrée d'un comparateur 52, dont une deuxième entrée est reliée à la masse et dont la sortie fournit un bit dans un élément de mémorisation 44 du type de celui illustré en figure 7. Il s'agit par exemple d'un registre destiné à contenir un mot W sur six bits et un bit R indicateur de la plage du signal d'entrée. Le comparateur 52 est susceptible d'être réinitialisé au moyen d'un interrupteur K reliant sa première entrée à sa sortie et qui est commandé par un signal RST (cet interrupteur sert à annuler l'erreur de tension de comparateur et peut être connecté à la masse si le comparateur est suffisamment précis ou si un autre moyen est utilisé pour annuler cette erreur). Des premières entrées communes des commutateurs K511 à K513 reçoivent un niveau L fourni par un sélecteur K5 entre le niveau Vref de pleine échelle du convertisseur et un niveau intermédiaire TH (égal à Vref/$2^k$), prélevé au point milieu d'un pont diviseur résistif comportant deux résistances R1 et R2 en série entre la borne d'application du niveau Vref et la masse. Des deuxièmes entrées respectives communes des interrupteurs K511 à K513 sont connectées à la masse. Des troisièmes entrées communes des interrupteurs K511 à K513 sont connectées à une borne d'application du signal Vin à numériser. L'ensemble est synchronisé en fonction d'une fréquence d'échantillonnage correspondant au rythme des approximations successives.

Le fonctionnement du convertisseur de la figure 8 est le suivant. Le signal analogique Vin est appliqué sur les entrées correspondantes des interrupteurs K511 à K513.

Lors de l'échantillonnage, l'interrupteur K de réinitialisation du comparateur 52 est fermé pour stocker le signal Vin dans les capacités respectives C, 2C et 4C. Puis, l'interrupteur K est ouvert et l'interrupteur K5 prend la référence TH alors que les interrupteurs K511 à K513 sont commutés vers cette référence. L'équilibre des charges entre les différentes capacités permet de comparer le niveau du signal par rapport au niveau Vref/$2^k$. Ce résultat est stocké dans le bit R définissant la plage correspondante du signal Vin. L'interrupteur K5 est alors commuté entre l'une de ses deux positions jusqu'à la fin de la conversion pour définir la plage de comparaison du signal en sélectionnant le niveau Vref ou le niveau TH. Puis, les capacités C, 2C et 4C et les commutateurs K511 à K513 sont utilisés, de façon usuelle, comme dans un convertisseur à redistribution de charges (convertisseur à approximations successives à capacités commutées).

En fin de période de comparaison, les résultats respectifs R et W sont exploités pour former le mot Wout (non représenté).

Les étapes d'application du niveau TH aux capacités C, 2C et 4C pour y comparer le niveau Vin, et de sélection de la plage de comparaison remplacent les étapes de détermination des bits de poids fort d'un convertisseur à capacités commutées usuel.

En prenant l'exemple d'un niveau TH égal à 1/8 du niveau Vref (k=3), le convertisseur à capacités commutées de la figure 8 permet, par rapport à un convertisseur à capacités commutées usuel, d'augmenter la résolution de 3 bits au prix d'une faible augmentation de surface. Dans un convertisseur à capacités commutées usuel, ajouter 1 bit de résolution requiert de multiplier la surface par environ 8 (le nombre de résistances et capacités servant à la subdivision de tension est multiplié par 2, d'où une surface environ quatre fois plus importante et chaque subdivision doit être de l'ordre de deux fois plus précise, d'où une surface environ double pour des questions d'appariement des composants). Augmenter la résolution de trois bits requiert un facteur de surface de plus de 500 ($8^3$).

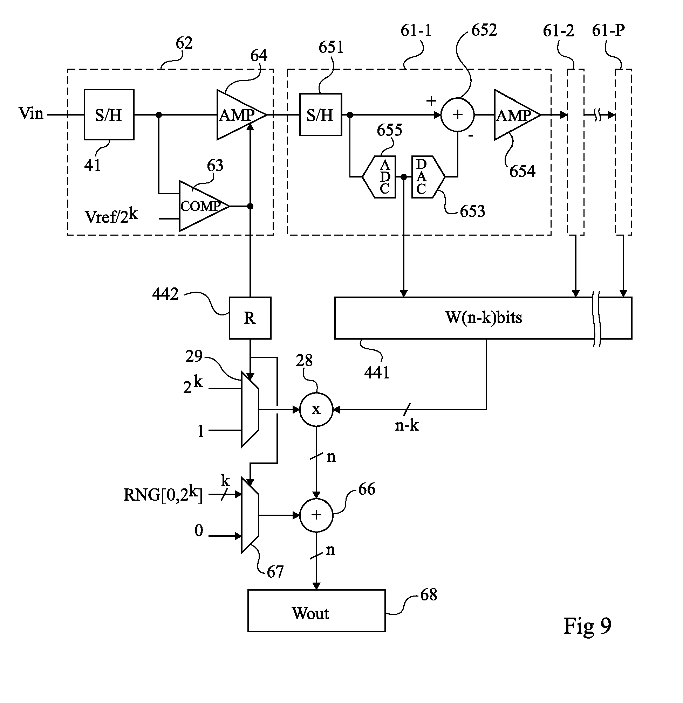

La figure 9 représente un mode de réalisation d'un convertisseur analogique-numérique respectant une architecture dite en pipeline. Une telle architecture utilise plusieurs étages 61-1, 61-2, 61-p sur un même nombre de bits et utilise le principe de replacer le signal à chaque fois en pleine amplitude pour l'étage suivant.

La contribution de ce mode de réalisation à un convertisseur pipeline usuel est d'ajouter un premier étage 62 de détermination de la plage du signal à convertir. Le niveau analogique Vin est envoyé sur un circuit 41 d'échantillonnage dont la sortie est comparée (comparateur 63) par rapport au niveau $Vref/2^k$ correspondant au seuil entre les deux plages. La sortie du comparateur 63 conditionne le gain d'un amplificateur 64 pour entrer dans l'étage suivant 61-1. Par ailleurs, cette sortie est mémorisée (bloc 442) pour stocker le bit R. Les étages successifs 61-1 à 61-p sont tous similaires et comportent chacun un échantillonneur-bloqueur 651 (S/H) du signal fourni par l'étage précédent (sortie de son amplificateur). La sortie de l'échantillonneur-bloqueur 651 est envoyée sur un sommateur/soustracteur 652 dont l'autre entrée reçoit le résultat d'une conversion numérique-analogique 653 (DAC) du résultat d'une conversion analogique-numérique 655 (ADC) de la sortie de l'échantillonneur-bloqueur 651. La sortie du convertisseur 655 est également envoyée au registre 441 de stockage du mot W sur n-k bits. La sortie du sommateur/soustracteur 652 est envoyée en entrée d'un amplificateur 654 (AMP) dont la sortie est envoyée en entrée de l'étage suivant. En supposant un convertisseur dont chaque étage est sur un bit, le convertisseur comporte autant d'étage que le mot W comporte de bits, c'est-à-dire n-k, et chaque étage fournit un ou plusieurs bits au registre 44 selon le nombre de bits par étage. D'autres versions de convertisseurs pipeline peuvent être utilisées en utilisant plusieurs bits par étage de façon usuelle. En fin de conversion, le bit contenu dans le registre 442 est utilisé par le multiplieur 28. La figure 9 illustre une variante dans laquelle, si le bit R vaut 1, un nombre compris entre 0 et $2^k$ tiré aléatoirement est ajouté (ou soustrait) au résultat du multiplieur 28. Cela évite que les k bits de poids faible soient à 0 pour des signaux d'amplitude élevée. Cette fonctionnalité est illustrée par un additionneur 66 recevant la sortie du multiplieur 28 et la sortie du sélecteur 67 entre une valeur aléatoire $RNG[0, 2^k]$ (ou $RNG[-2^k, 2^k]$) et la valeur 0. Le sélecteur est commandé par le bit R et la sortie de l'additionneur 66 fournit le mot Wout stocké dans le registre 68. Cette variante est applicable à tous les modes de réalisation décrits.

Les différents signaux de synchronisation des éléments représentés aux figures 3, 5, 7, 8 et 9 n'ont pas été détaillés. Cette synchronisation étant à la portée de l'homme du métier à partir des indications fonctionnelles indiquées.

Un avantage des modes de réalisation décrits est qu'ils permettent d'utiliser un convertisseur analogique-numérique sur un nombre de bits restreint par rapport au nombre de bits finalement obtenu.

Il en découle une économie de surface et de temps pour la réalisation de la conversion.

Divers modes de réalisation ont été décrits, diverses variantes et modifications apparaîtront à l'homme de l'art. En particulier, bien que trois exemples de convertisseur analogique-numérique aient été décrits, l'invention s'applique plus généralement quelle que soit l'architecture du convertisseur, pourvu que cette architecture soit compatible avec l'exécution d'une précomparaison pour déterminer la plage du signal utile.

De plus, le choix du nombre k de bits déterminant la plage du convertisseur est à la portée de l'homme du métier en fonction de l'application et plus précisément de l'évolution du bruit dans le signal à convertir.

En outre, bien que la description ait fait référence à une comparaison dont le résultat fournit un bit drapeau R à l'état 1 pour la plage supérieure, le résultat de la comparaison pourra être inversé, pourvu d'adapter les traitements ultérieurs afin que le mot binaire final soit formé, par exemple, par multiplication de la conversion sur n-k bits par $2^k$ lorsque le signal analogique à convertir est supérieur au seuil TH.

Enfin, la mise en oeuvre pratique est à la portée de l'homme du métier à partir des indications fonctionnelles données ci-dessus.

## Revendications

**1.** Procédé de conversion analogique-numérique sur n bits d'un signal analogique (Vin), **caractérisé en ce qu'**il comporte les étapes de :

comparer l'amplitude du signal analogique par rapport à un seuil représentant l'amplitude (Vref) du signal analogique à pleine échelle divisée par $2^k$, où k est un entier inférieur à n ; effectuer une conversion analogique-numérique du signal analogique sur n-k bits pour obtenir les n-k bits de poids fort d'un mot binaire sur n bits si le résultat de l'étape de comparaison indique que l'amplitude du signal d'entrée est supérieure au seuil, et les n-k bits de poids faible de ce mot binaire sinon.

**2.** Procédé selon la revendication 1, dans lequel la conversion analogique-numérique sur n-k bits prend pour valeur de pleine échelle, une valeur égale à $Vref/2^{(k*(1-R))}$, le quantum de la conversion sur n-k bits valant alors $Vref/2^{(n-k*R)}$, où R représente une variable binaire prenant la valeur 0 si l'amplitude du signal analogique est inférieure ou égale au seuil et la valeur 1 sinon ; et le mot binaire sur n bits est formé en multipliant le résultat de ladite conversion sur n-k bits par $2^{(k*R)}$.

**3.** Procédé selon la revendication 1 ou 2 dans lequel, si l'amplitude du signal d'entrée est supérieure au seuil, les k bits de poids faible du mot sur n bits sont obtenus de façon aléatoire.

**4.** Convertisseur analogique-numérique sur n bits d'un signal analogique, **caractérisé en ce qu'**il comporte :

un élément (21 ; 32 ; 42, 43 ; 51, 52 ; 62) de comparaison de l'amplitude du signal analogique par rapport à un seuil (TH) représentant l'amplitude (Vref) du signal analogique à pleine échelle divisée par $2^k$, où k est un entier inférieur à n ; et

un élément (25 ; 31, 32 ; 42, 43 ; 51, 52 ; 61-1, 61-2, 61-p) de conversion analogique-numérique du signal analogique sur n-k bits pour obtenir les n-k bits de poids fort d'un mot binaire sur n bits si le résultat de l'étape de comparaison indique que l'amplitude du signal d'entrée est supérieure au seuil, et les n-k bits de poids faible de ce mot binaire sur n bits sinon.

5. Convertisseur selon la revendication 4, comportant en outre :

un élément (33 ; 442) de mémorisation d'une information binaire R fournie par l'élément de comparaison et valant 1 si l'amplitude du signal analogique est supérieure au seuil ; et

au moins un premier élément numérique (28, 29) apte à former un mot binaire sur n bits en multipliant la valeur obtenue en sortie de l'élément de conversion sur n-k bits par $2^{k*R}$, la pleine échelle de l'élément de conversion analogique-numérique sur n-k bits étant ajustée à la valeur $Vref/2^{(k*R)}$.

6. Convertisseur selon la revendication 5, comportant en outre un second élément numérique (66, 67) apte à additionner, dans le cas où l'information binaire R vaut 1, un nombre aléatoire au mot binaire sur n bits fourni par le premier élément numérique, la sortie du deuxième élément numérique constituant la sortie du convertisseur.

7. Convertisseur selon la revendication 5 ou 6, dans lequel l'élément de conversion est un convertisseur à rampe utilisant deux rampes distinctes (LRAMP, HRAMP) dont le rapport des pentes vaut $2^k$, le convertisseur comportant en outre un élément (K1, K2) de connexion dudit élément de comparaison à l'une des deux rampes en fonction de la valeur de l'information binaire R.

8. Convertisseur selon la revendication 5 ou 6, dans lequel l'élément de conversion est à approximations successives, lesdits éléments de comparaison et de conversion étant constitués d'un même comparateur (43 ; 51, 52) et le convertisseur comportant en outre un élément (45 ; K5) de sélection de la valeur de pleine échelle en fonction de la valeur de l'information binaire R.

9. Convertisseur selon la revendication 5 ou 6, dans lequel l'élément de conversion est de type pipeline, le convertisseur comportant en outre, en amont de l'élément de conversion, un étage (62) dont le gain est sélectionné en fonction de la valeur de l'information binaire R.

10. Capteur d'images comportant :

un réseau (11) de pixels comportant chacun au moins un élément de stockage d'une information de luminance ;
au moins un convertisseur analogique-numérique (12) conforme à l'une quelconque des revendications 4 à 9 ; et
au moins un élément de mémorisation (13).

11. Système électronique comportant :

au moins un circuit (11) apte à fournir un signal analogique à convertir en signal numérique ;
au moins un convertisseur analogique-numérique (12) conforme à l'une quelconque des revendications 4 à 9 ; et
au moins un circuit (13) apte à exploiter le signal numérique.

Fig 1

Fig 2

Fig 3

Fig 4

Fig 5

Fig 6A

Fig 6B

Fig 6C

Fig 6D

Fig 6E

Fig 6F

Fig 7

Fig 8

Fig 9

Europäisches
Patentamt

European
Patent Office

Office européen
des brevets

**RAPPORT DE RECHERCHE EUROPEENNE**

Numéro de la demande

EP 09 16 6339

## DOCUMENTS CONSIDERES COMME PERTINENTS

| Catégorie | Citation du document avec indication, en cas de besoin, des parties pertinentes | Revendication concernée | CLASSEMENT DE LA DEMANDE    (IPC) |
|---|---|---|---|
| A | JP 59 143420 A (VICTOR COMPANY OF JAPAN) 17 août 1984 (1984-08-17) * abrégé; figures 2,3 * ----- | 1,4 | INV. H03M1/20 H03M1/18  ADD. H03M1/16 H03M1/44 H03M1/46 H03M1/56 |

**DOMAINES TECHNIQUES RECHERCHES   (IPC)**

H03M

Le présent rapport a été établi pour toutes les revendications

| Lieu de la recherche | Date d'achèvement de la recherche | Examinateur |
|---|---|---|
| La Haye | 7 janvier 2010 | Beindorff, Henk |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons
........................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 09 16 6339

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

07-01-2010

| Document brevet cité<br>au rapport de recherche | Date de<br>publication | Membre(s) de la<br>famille de brevet(s) | Date de<br>publication |
|---|---|---|---|
| JP 59143420 A | 17-08-1984 | AUCUN | |

EPO FORM P0460

## RÉFÉRENCES CITÉES DANS LA DESCRIPTION

### Littérature non-brevet citée dans la description

- **M.F. Snoeij et al.** *A Low-Power Column-Parallel 12-bit ADC for CMOS Imagers,* Juin 2005